**Europäisches Patentamt**

**European Patent Office**

**Office européen des brevets**

(11) Veröffentlichungsnummer: **0 241 675 B1**

# (12) EUROPÄISCHE PATENTSCHRIFT

(45) Veröffentlichungstag der Patentschrift:
09.01.91 Patentblatt 91/02

(51) Int. Cl.$^5$: **H05K 7/02, H01R 13/405,** H01R 13/52, H01R 43/24

(21) Anmeldenummer: **87102433.7**

(22) Anmeldetag: **20.02.87**

(54) **Elektrisches Bauteil mit Kunststoffmantel und Verfahren zu dessen Herstellung.**

(30) Priorität: **15.04.86 DE 3612576**

(43) Veröffentlichungstag der Anmeldung:
**21.10.87 Patentblatt 87/43**

(45) Bekanntmachung des Hinweises auf die Patenterteilung:
**09.01.91 Patentblatt 91/02**

(84) Benannte Vertragsstaaten:
**AT CH DE ES FR GB IT LI**

(56) Entgegenhaltungen:
**FR-A- 2 245 102**
**FR-A- 2 557 385**

(73) Patentinhaber: **Preh-Werke GmbH & Co. KG**
**Postfach 1740 An der Stadthalle**
**D-8740 Bad Neustadt/Saale (DE)**

(72) Erfinder: **Schmitt, Herbert**
**Waldsiedlung 22**
**D-8740 Bad Neustadt/Saale (DE)**
Erfinder: **Winkler, Helmut**
**Nachtigallweg 24**
**D-8740 Bad Neustadt/Saale (DE)**
Erfinder: **Krause, Dietrich**
**Schreiberstrasse 21**
**D-8740 Bad Neustadt/Saale (DE)**

## Beschreibung

Die Erfindung betrifft ein elektrisches Bauteil mit Leiterzügen und Anschlußstellen und einem die Leiterzüge umschließenden und die Anschlußstellen freilassenden Kunststoffmantel (siehe z.B. FR-A-2557385).

In der DE-PS 27 25 796 ist eine elektrische Steckdose mit in einem Gehäuse aus Thermoplast eingeschlossenen Stiftkontakten beschrieben. Eine solche Steckdose soll dicht sein, damit sich Umwelteinflüsse nicht auf die elektrischen Leiter auswirken können.

Werden Leiterzüge in den Kunststoffmantel eingespritzt, so gilt es im besonderen bei langen, mechanisch unzulänglich stabilen, flächigen oder mit geringem Abstand zueinander liegenden Leiterzügen Maßnahmen zu ergreifen, die gewährleisten, daß die Anschlußstellen innerhalb enger Toleranzgrenzen in ihrer vorbestimmten Position freiliegen und die Leitungszüge selbst in der vorgesehenen Lage im Kunststoffmantel eingebettet sind. Es sind nach dem Stand der Technik hierfür in der Spritzform Anschlagstifte vorgesehen, die z.B. auf die Leiterzüge drücken und diese in einer gewünschten Lage in der Form halten. Nach dem Umspritzen des Kunststoffmantels liegen dort, wo die Stifte auf die Leiterzüge drückten, die Leiterzüge frei. An diesen Stellen wirken Umwelteinflüsse auf die Leiterzüge. Die Leiterzüge können dabei im Laufe der Zeit Schaden nehmen. Dies insbesondere dann, wenn das Bauteil in einen Raum, wie beispielsweise einem Motorraum eines kraftfahrzeuges, mit aggressiver Atmosphäre montiert ist. Die offenen Stellen der Leiterzüge einzeln nachträglich zu schließen, wäre sehr aufwendig. Der Erfolg dieser Maßnahme wäre darüber hinaus zweifelhaft, da diese Stellen gewöhnlich klein sind.

Aufgabe der Erfindung ist es, ein Bauteil der eingangs genannten Art vorzuschlagen, dessen Leiterzüge einerseits in einem bestimmten Abstand zum Kunststoffmantel stehen und andererseits am Mantel in Zwischenbereichen nicht freiliegen, ohne daß der Mantel in Zwischenbereichen nachträglich geschlossen werden muß.

Erfindungsgemäß ist obige Aufgabe bei einem Bauteil der eingangs genannten Art dadurch gelöst, daß die Leiterzüge gegeneinander von einem ihren Querschnitt bereichsweise umgreifenden Kunststoffträger gehalten sind, der wenigstens einige zur Lage der Leiterzüge maßgenaue Abstandsflächen bildet, und daß der Kunststoffträger und die Leiterzüge von dem Kunststoffmantel umhüllt sind.

Die Leiterzüge sind durch den Kunststoffträger einerseits in ihrer gegenseitigen Zuordnung lagerichtig gehalten. Andererseits stehen die Abstandsflächen zu den Leiterzügen maßgenau. Dadurch können Abstandhalterstifte der Form, in der der Kunststoffmantel aufgebracht wird, auf diesen Abstandsflächen aufstehen. Nach dem Aufspritzen des Kunststoffmantels liegen die Leiterzüge im Bereich der Abstandsstifte nicht frei, da sie dort durch den Kunststoffträger, insbesondere dessen Abstandsflächen abgedeckt sind. Nach dem Aufbringen des Kunststoffmantels sind weitere Verfahrensschritte zur Abdeckung der Leiterzüge in Zwischenbereichen überflüssig.

In bevorzugter Ausgestaltung der Erfindung sind die Anschlagsflächen zur Positionierung der Leiterzüge und der Anschlußstellen im elektrischen Bauteil an, an dem Kunststoffträger ausgeformten Stiften oder Stegen gebildet. Es erübrigen sich dann Abstandhalterstifte in der Form, in der der Kunststoffmantel aufgebracht wird.

In Weiterbildung der Erfindung sind die Leiterzüge an einem oder mehreren Stanzteilen ausgebildet und die Stanzteile sind in den Kunststoffmantel eingebettet. Dadurch ist es möglich, im Kunststoffmantel eine Vielzahl von Leiterzügen anzuordnen, die zum Anschluß von Schaltungselementen dienen, die erst nach der Herstellung des Bauteils montiert werden.

Ein erfindungsgemäßes Verfahren zur Herstellung des Bauteils zeichnet sich dadurch aus, daß ein die Leiterzüge und Anschlußstellen aufweisendes Stanzteil mit dem Kunststoffträger bereichsweise so umspritzt wird, daß die Leiterzüge im vorgesehenen Abstand fixiert werden, daß danach zwischen den Leiterzügen bestehende Verbindungsstege des Stanzteils getrennt werden und daß dann das Stanzteil bzw. ein oder mehrere Stanzteile in eine Form eingelegt werden, wobei die Abstandsflächen den notwendigen Abstand zur Form halten und das Stanzteil bzw. die Stanzteile mit dem Kunststoffmantel umspritzt werden.

Weitere vorteilhafte Ausgestaltungen der Erfindung ergeben sich aus der folgenden Beschreibung eines Ausführungsbeispiels.

In der Zeichnung zeigen :

Figur 1 ein Leiterzüge und Anschlußstellen bildendes Stanzteil in Aufsicht,

Figur 2 eine Ansicht des Stanzteils in Richtung der Linie II-II nach Figur 1,

Figur 3 das Stanzteil mit einem Kunststoffträger umspritzt in Aufsicht,

Figur 4 das Stanzteil nach Figur 3 in Seitenansicht längs der Linie IV-IV,

Figur 5 das mit dem Kunststoffträger und einem Kunststoffmantel umspritzte Stanzteil in geschnittener Aufsicht längs der Linie V-V nach Figur 6,

Figur 6 das Stanzteil nach Figur 5 in Ansicht längs der Linie VI-VI nach Figur 5 und

Figur 7 das anschlußfertige Bauteil in Ansicht längs der Linie VII-VII nach Figur 6.

Ein Stanzteil (1) aus einem elektrisch leitenden Blech weist vier Leiterzüge (2, 3, 4, 5) auf. An deren Enden sind Anschlußstellen (6, 7, 8, 9 bzw. 10, 11, 12, 13) vorgesehen. Die Anschlußstellen (6, 7, 8, 9) liegen auf einem Kreis. Die Anschlußstelle (12) ist von einer Hülse gebildet, die am Ende des Leiterzugs (4) befestigt ist ; in ihr angeordnet ist die stiftförmige Anschlußstelle (11), befestigt am Ende des Leiterzugs (3). Die Anschlußstelle (10) ist als Lötkontakt für einen Leiter ausgebildet, sie ist aus der Ebene der Leiterzüge abgebogen. Die Leiterzüge und die Anschlußstellen sind entsprechend des jeweiligen Bedarfsfalles ausgebildet.

Die Leiterzüge (2, 3, 4, 5) sind am Stanzteil (1) noch durch Stege (14) verbunden, so daß das Stanzteil (1) eine zusammenhängende Baueinheit bildet.

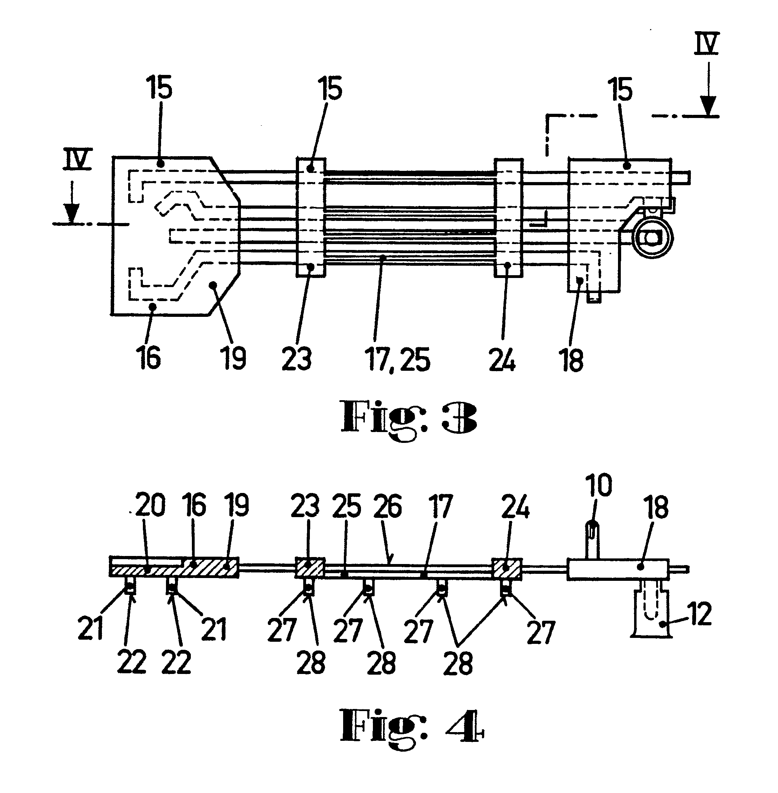

Das beschriebene Stanzteil (1) wird mit einem Kunststoffträger (15) bereichsweise umspritzt (vgl. Figur 3). Der Kunststoffträger (15) weist dabei im Beispielsfalle drei separate Abschnitte (16, 17, 18) auf. Der Abschnitt (16) umgreift in einem Bereich (19) alle vier Leiterzüge (2, 3, 4, 5) und fixiert deren Abstand. In einem Bereich (20) liegt der Abschnitt (16) des Kunststoffträgers (15) nur einseitig der Anschlußstellen (6, 7, 8, 9), so daß er diese oben freiläßt (vgl. Figur 4). Im Bereich (20) sind Stifte (21) ausgeformt, deren freie Enden Abstandsflächen (22) bilden.

Im Abschnitt (17) umgreift der Kunststoffträger (15) alle vier Leiterzüge (2, 3, 4, 5) in beabstandeten Bereichen (23 und 24). Zwischen den Bereichen (23 und 24) verlaufen an der einen Seite der Leiterzüge (2, 3, 4, 5) einseitig Bereiche (25) des Abschnitts (17). Auf der den Bereichen (25) gegenüberliegenden Seite (26) sind die Leiterzüge (2, 3, 4, 5) frei vom Kunststoffträger (15). An den Bereichen (23, 24, 25) sind Stifte (27) ausgeformt, deren freie Enden Anschlagflächen (28) bilden (vgl. Figur 4).

Der Abschnitt (18) umgreift die Leiterzüge (2, 3, 4, 5) vor den Anschlußstellen (10, 11, 12, 13). Er hält den notwendigen Abstand der Leiterzüge (2, 3, 4, 5) im Bereich der Anschlußstellen (10, 11, 12, 13). Aufgrund der mehrmaligen Fixierung der Leiterzüge (2, 3, 4, 5) längs der Längserstreckung kann für diese z.B. auch ein weiches, leicht verbeigbares Material, das sich zum bonden elektrischer Bauteile vorteilhaft eignet, verwendet werden.

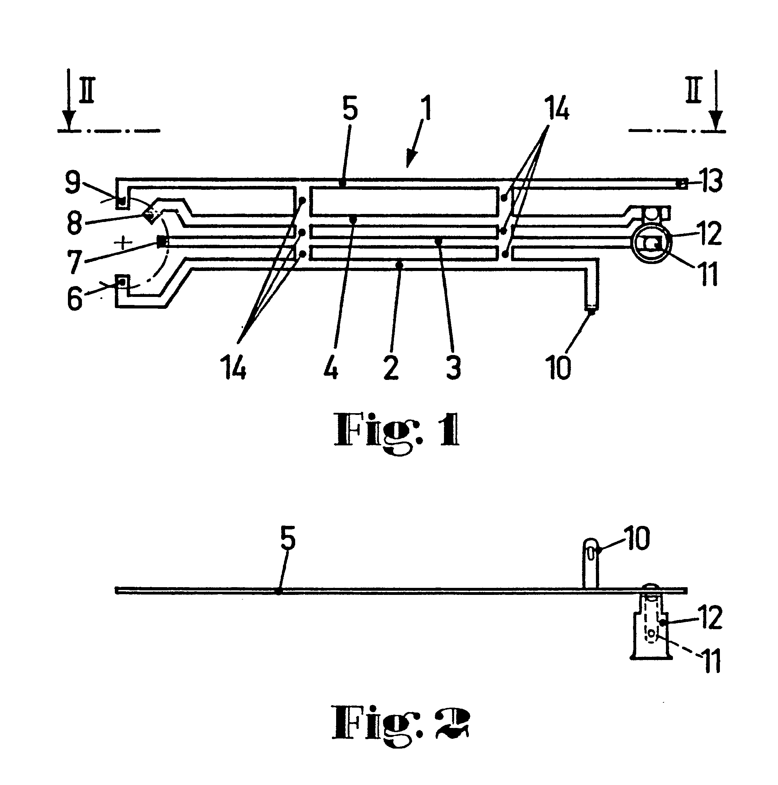

Nach dem Aushärten der Abschnitte (16 bis 18) des Kunststoffträgers (15) werden die Stege (14) durchtrennt (vgl. Figur 1 mit Figur 3). Dadurch sind die Leiterzüge (2, 3, 4, 5) elektrisch voneinander frei, jedoch über die Abschnitte (16 bis 18), insbesondere deren Bereiche (18, 19, 23, 24) miteinander in der richtigen Lage mechanisch verbunden.

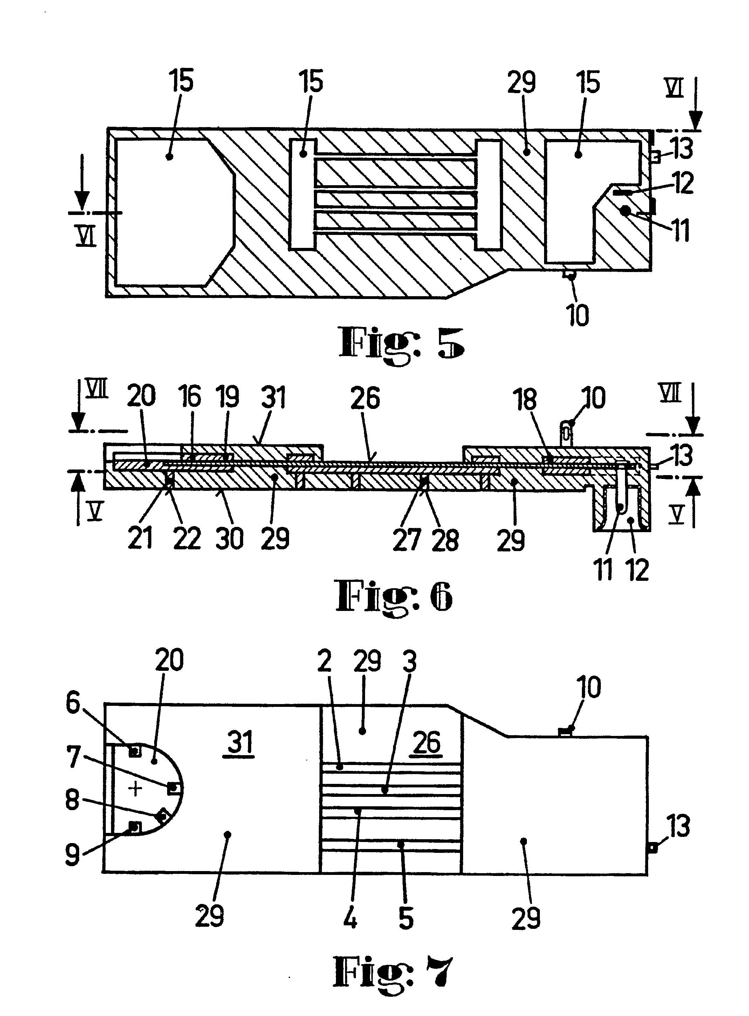

Anschließend wird die so geschaffene Baueinheit in eine Form eingelegt. Dabei stehen die Abstandsflächen (22 und 28) auf der einen Formhälfte auf und stellen den notwendigen Abstand zwischen der Form und den Leiterzügen (2, 3, 4, 5) sicher. Es Wird dann in die Form Kunststoffmasse eingespritzt, die den Kunststoffmantel (29) bildet. Auf der Unterseite (30) erstreckt sich der Kunststoffmantel (29) durchgehend über die Anschlußstellen (6, 7, 8, 9) und die Leiterzüge (2, 3, 4, 5) um die Stifte (21, 27) bis zu den Anschlußstellen (10, 11, 12, 13) (vgl. Figur 5). Auf der Oberseite (31) läßt der Kunststoffmantel (29) die Anschlußstellen (6, 7, 8, 9) frei. Er läßt im Beispielsfalle außerdem die Leiterzüge (2, 3, 4, 5) in der Zone zwischen den Bereichen (23 und 24) frei (vgl. (26) in Figur 6 und Figur 7). Es können dann dort an die Leiterzüge (2, 3, 4, 5) elektrische Bauteile angeschlossen werden. Ist dies überflüssig, dann erstreckt sich der Kunststoffmantel (29) an der Oberseite (31) durchgehend zwischen den Anschlußstellen (6, 7, 8, 9) und den Anschlußstellen (10, 11, 12, 13).

Bei dem beschriebenen Bauteil liegen die Leiterzüge (2, 3, 4, 5) nur an solchen Stellen offen, die für deren elektrischen Anschluß nötig sind. Die Leiterzüge (2, 3, 4, 5) liegen nicht an solchen Stellen offen, die im Herstellungsverfahren dem Einhalten des notwendigen Abstandes zwischen der Oberfläche des Kunststoffmantels (29) und den Leiterzügen (2, 3, 4, 5) dienen. Sie sind im Bereich der zur Abstandschaffung vorgesehenen Stifte (21, 27) dicht abgeschlossen. Die Stifte (21, 27) erübrigen Stifte der Form. Es könnten jedoch auch stifte in der Form vorgesehen werden, die dann auf den Abschnitten (16, 17, 18) aufstehen. Auch in diesem Falle wären die Leiterzüge (2, 3, 4, 5) durch die Abschnitte (16, 17, 18) am fertigen Bauteil gegenüber der Umgebung abgedeckt.

Als Material für den Kunststoffträger (15) und den Kunststoffmantel (29) können gleiche Kunststoffe verwendet werden. Es ist jedoch auch möglich, für den Kunststoffträger (15) einen anderen Kunststoff als für den Kunststoffmantel (29) zu verwenden. Beispielsweise kann für den Kunststoffträger (15), insbesondere dessen Abschnitt (17), ein elektrisch hochohmiger Kunststoff verwendet werden, dessen spezifischer elektrischer Widerstand niederohmiger als der des Kunststoffmantels (29) ist. Dadurch lassen sich kapazitive Koppelwirkungen zwischen den Leiterzügen (2, 3, 4, 5) unterdrücken.

Es ist auch möglich, den Kunststoffträger (15) aus einem lichtleitenden Material vorzusehen und den Kunststoffträger (15) durchgehend zwischen den Anschlußstellen (6 bzw. 7 bzw. 8 bzw. 9) und den

3

Anschlußstellen (10 bzw. 11 bzw. 12 bzw. 13) anzuordnen. Es kann dann eine optische Kopplung zwischen den Anschlußstellen erreicht werden. Es kann auch eine optische Kopplung zwischen der Zone zwischen den Bereichen (23 und 24) und den Anschlußstellen geschaffen werden.

Ist durch die Strombelastung der Leiterzüge (2, 3, 4, 5) oder beim Verbinden von Anschlußelementen an den Anschlußstellen (6 bis 13) mit einer erheblichen Erwärmung zu rechnen, dann kann für den Kunststoffträger (15) auch ein hochtemperaturbeständiges Kunststoffmaterial ausgewählt werden.

In vielen Fällen wird es jedoch genügen, für den Kunststoffträger (15) einen billigen Kunststoff, wie beispielsweise Polypropylen zu verwenden und nur den Kunststoffmantel (29) aus einem teureren, spezielle Eigenschaften aufweisenden, so z.B. gegen hohe Temperaturen und/oder Chemikalien beständigen und schlagzähen Kunststoff zu fertigen.

Bezugszeichenliste 07/86 Pt.

| | |
|---|---|
| 1 | Stanzteil |
| 2 | Leiterzug |
| 3 | Leiterzug |
| 4 | Leiterzug |
| 5 | Leiterzug |
| 6 | Anschlußstelle |
| 7 | Anschlußstelle |
| 8 | Anschlußstelle |
| 9 | Anschlußstelle |
| 10 | Anschlußstelle (Hülse) |
| 11 | Anschlußstelle (Stift) |
| 12 | Anschlußstelle |
| 13 | Anschlußstelle |
| 14 | Steg |
| 15 | Kunststoffträger |
| 16 | Abschnitt |
| 17 | Abschnitt |
| 18 | Abschnitt |
| 19 | Bereich |
| 20 | Bereich |
| 21 | Stift |
| 22 | Abstandsfläche |
| 23 | Bereich |
| 24 | Bereich |
| 25 | Bereich |
| 26 | Seite |
| 27 | Stift |
| 28 | Abstandsfläche |
| 29 | Kunststoffmantel |
| 30 | Unterseite |
| 31 | Oberseite |

## Ansprüche

1. Elecktrisches Bauteil mit Leiterzügen und Anschlußstellen und einem die Leiterzüge umschließenden und die Anschlußstellen freilassenden Kunststoffmantel, dadurch gekennzeichnet, daß die Leiterzüge (2, 3, 4, 5) gegeneinander von einem ihren Querschnitt bereichsweise umgreifenden Kunststoffträger (15) gehalten sind, der wenigstens einige zur Lage der Leiterzüge (2, 3, 4, 5) maßgenaue Abstandsflächen (22, 28) bildet, und

daß der Kunststoffträger (15) und die Leiterzüge (2, 3, 4, 5) von dem Kunststoffmantel (29) umhüllt sind.

2. Bauteil nach Anspruch 1, dadurch gekennzeichnet, daß die Abstandsflächen (22, 28) von an dem Kunststoffträger (15) ausgeformten Stiften (21, 27) gebildet sind.

3. Bauteil nach Anspruch 1 oder 2, dadurch gekennzeichnet, daß die Leiterzüge (2, 3, 4, 5) an einem oder mehreren Stanzteilen (1) ausgebildet sind und daß die Stanzteile (1) in den Kunststoffmantel (29) eingebettet sind.

4. Bauteil nach einem der vorhergehenden Ansprüche, dadurch gekennzeichnet, daß der Kunststoffträger (15) in mehreren einzelnen Abschnitten (16, 17, 18) die Leiterzüge (2, 3, 4, 5) umgreift.

5. Bauteil nach einem der vorhergehenden Ansprüche, dadurch gekennzeichnet, daß der Kunststoffträger (15) in einzelnen Bereichen (20, 26) die Leiterzüge (2, 3, 4, 5) einseitig freiläßt.

6. Bauteil nach einem der vorhergehenden Ansprüche, dadurch gekennzeichnet, daß der Kunststoffträger (15) aus dem gleichen Material besteht, wie der Kunststoffmnatel (29).

7. Bauteil nach einem der vorhergehenden Ansprüche 1 bis 5, dadurch gekennzeichnet, daß der Kunststoffträger (15) aus einem Material besteht, das einen hohen elektrischen Widerstand aufweist, der jedoch niedriger als der des Kunststoffmantels (29) ist.

8. Bauteil nach einem der vorhergehenden Ansprüche 1 bis 5, dadurch gekennzeichnet, daß der Kunststoffträger (15) aus einem lichtleitenden Material gebildet ist, das bis zu den Anschlußstellen (6 bis 13) geführt ist.

9. Verfahren zur Herstellung eines Bauteils nach einem der vorhergehenden Ansprüche, dadurch gekennzeichnet, daß ein die Leiterzüge und Anschlußstellen aufweisendes Stanzteil mit dem Kunststoffträger bereichsweise so umspritzt wird, daß die Leiterzüge im vorgesehenen Abstand fixiert werden, daß danach zwischen den Leiterzügen bestehende Verbindungsstege des Stanzteils getrennt werden und daß dann das Stanzteil bzw. ein oder mehrere Stanzteile in eine Form eingelegt werden, wobei die Abstandsflächen den notwendigen Abstand zur Form halten, und das Stanzteil bzw. die Stanzteile mit dem Kunststoffmantel umspritzt werden.

## Claims

1. An electrical component with strip conductors and terminals and a plastic jacket surrounding the strip conductors and leaving the terminals exposed, characterised in that the strip conductors (2, 3, 4, 5) are held against each other by a plastic carrier (15) enclosing their cross-section in regions, the carrier forming at least some spacer faces (22, 28) dimensionally true to the position of the strip conductors (2, 3, 4, 5) and in that the plastic carrier (15) and the strip conductors (2, 3, 4, 5) are covered by the plastic jacket (29).

2. A component according to claim 1, characterised in that the spacer faces (22, 28) are formed by pins (21, 27) shaped in the plastic carrier (15).

3. A component part according to claim 1 or 2, characterised in that the strip conductors (2, 3, 4, 5) are formed as one or several punched parts (1) and in that the punched parts (1) are embedded in the plastic jacket (29).

4. A component part according to one of the preceding claims, characterised in that the plastic carrier (15) encloses the strip conductors (2, 3, 4, 5) in several individual sections (16, 17, 18).

5. A component part according to one of the preceding claims, characterised in that the plastic carrier (15) leaves the strip conductors (2, 3, 4, 5) exposed on one side in individual regions (20, 26).

6. A component part according to one of the preceding claims, characterised in that the plastic carrier (15) consists of the same material as the plastic jacket (29).

7. A component part according to one of the preceding claims 1 to 5, characterised in that the plastic carrier (15) is of a material which has a high electrical resistance, which is nevertheless lower than that of the plastic jacket (29).

8. A component according to one of the preceding claims 1 to 5, characterised in that the plastic carrier (15) is formed from a light-conducting material which leads up to the terminals (6 to 13).

9. A method for manufacturing a component according to one of the preceding claims, characterised in that a punched part having the strip conductors and the terminals has the plastic carrier injected round it in regions, in that the strip conductors are fixed at the predetermined spacing, in that after this connecting bars of the punched part existing between the strip conductors are separated and in that then the punched part or one or several punched parts are laid in a mould, wherein the spacer faces keep the necessary spacing to the mould and the punched part or the punched parts have the plastic jacket injected round them.

## Revendications

1. Pièce détachée électrique, comportant des éléments conducteurs et des points de connexion ainsi qu'une enveloppe en matière synthétique ou plastique entourant les éléments conducteurs et laissant libres les points de connexion, pièce caractérisée en ce que les éléments conducteurs (2, 3, 4, 5) sont maintenus l'un par rapport à l'autre par un support (15) en matière plastique qui entoure une partie de leur section, ce support formant au moins quelques surfaces (22, 28) pour le positionnement précis des éléments conducteurs (2, 3, 4, 5), et en ce que le support (15) en matière plastique et les éléments conducteurs (2, 3, 4, 5) sont enveloppés par l'enveloppe (29) en matière plastique.

2. Pièce détachée selon la revendication 1, caractérisée en ce que les surfaces (22, 28) de positionnement sont formées sur des ergots (21, 27) venus de moulage sur le support (15) en matière plastique.

3. Pièce détachée selon la revendication 1 ou 2, caractérisée en ce que les éléments conducteurs (2, 3, 4, 5) sont formés sur une ou plusieurs pièces (1) découpée(s), et en ce que les pièces (1) découpées sont encastrées dans l'enveloppe (29) en matière plastique.

4. Pièce selon l'une des revendications précédentes, caractérisée en ce que le support (15) en matière plastique entoure, en plusieurs tronçons (16, 17, 18) individuels, les éléments conducteurs (2, 3, 4, 5).

5. Pièce détachée selon l'une des revendications précédentes, caractérisée en ce que le support (15) en matière plastique laisse libres d'un côté, dans certaines régions (20, 26), les éléments conducteurs (2, 3, 4, 5).

6. Pièce selon l'une des revendications précédentes, caractérisée en ce que le support (15) en matière plastique consiste en la même matière que l'enveloppe (29) en matière plastique.

7. Pièce détachée selon l'une des revendications 1 à 5 précédentes, caractérisée en ce que le support (15) en matière plastique consiste en une matière qui présente une résistance électrique élevée, mais cependant inférieure à celle de l'enveloppe (29) en matière plastique.

8. Pièce détachée selon l'une des revendications 1 à 5 précédentes, caractérisée en ce que le support (15) en matière plastique est constitué d'une matière conductrice de la lumière et qui est conduite jusqu'aux points (6 à 13) de connexion.

9. Procédé pour fabriquer une pièce détachée selon l'une des revendications précédentes, caractérisé en ce qu'on entoure, par extrusion, par zones, à l'aide d'un support en matière plastique une pièce découpée présentant les éléments conducteurs et les points de connexion ; en ce qu'on fixe à un écartement prédéterminé les éléments conducteurs ; en ce qu'on enlève ensuite les organes de liaison de la pièce découpée situés entre les éléments conducteurs et en ce qu'on place ensuite la pièce découpée ou bien une ou plusieurs pièces découpées dans un moule, les surfaces de positionnement maintenant la distance nécessaire par rapport au moule, et l'on entoure, par moulage ou extrusion, à l'aide de l'enveloppe en matière plastique, la pièce découpée ou bien les pièces découpées.

**Fig. 1**

**Fig. 2**

**Fig: 3**

**Fig: 4**

**Fig: 5**

**Fig: 6**

**Fig: 7**